Europäisches Patentamt

(19) European Patent Office

Office européen des brevets

(11) Publication number: **0 112 115**
**B1**

(12) **EUROPEAN PATENT SPECIFICATION**

(45) Date of publication of patent specification: **30.12.86**

(51) Int. Cl.⁴: **G 08 C 15/06, H 03 K 7/08**

(21) Application number: **83307403.2**

(22) Date of filing: **06.12.83**

(54) Sensor communication system.

(30) Priority: **08.12.82 US 447818**

(43) Date of publication of application:
**27.06.84 Bulletin 84/26**

(45) Publication of the grant of the patent:
**30.12.86 Bulletin 86/52**

(84) Designated Contracting States:
**DE FR GB IT NL**

(56) References cited:
**GB-A-2 024 570**
**US-A-3 714 470**
**US-A-3 819 864**

**ELECTRONIC DESIGN, vol. 30, no. 19,
September 1982, pages 125-129, Waseca, MN,
Denville, NJ, USA R. RUDDLE: "Software
meshes analog board with microcomputers"**

**NASA TECH BRIEF, 1977, NTN-77/0594,
Pasadena, USA "Low-cost pressure-data
encoder"**

**TOUTE L'ELECTRONIQUE, no. 415, November
1976, pages 49-53, Paris, FR. CH. BURNIAUX:
"Amplificateurs programmables: Conception
et applications"**

(73) Proprietor: **HONEYWELL INC.**
**Honeywell Plaza**
**Minneapolis Minnesota 55408 (US)**

(72) Inventor: **Bozarth, Theodore B.**
**623 Meadowbrook Lane**
**Perkasie Pennsylvania 18944 (US)**
Inventor: **Demark, Anthony M.**
**700 Gawain Road**
**Plymouth Meeting Pennsylvania 19462 (US)**
Inventor: **Finn, Edward F.**
**1360 Derby Road**
**Warminster Pennsylvania 18974 (US)**
Inventor: **Lynch, Frank**
**47 Bright Road**
**Hatboro Pennsylvania 19040 (US)**

(74) Representative: **Frohwitter, Bernhard, Dipl.-Ing.
et al
Bardehle-Pagenberg-Dost-Altenburg & Partner
Patent- und Rechtsanwälte Galileiplatz 1
Postfach 86 06 20
8000 München 80 (DE)**

(56) References cited:
**ELECTRONIC DESIGN, vol. 29, no. 7, 31st
March 1981, pages 84-88, Waseca, MN,
Denville, NJ, USA S. OHR: "Low-power analog
components bolster data acquisition"**

Courier Press, Leamington Spa, England.

## Description

The present invention relates to sensor communication systems, and more particularly to a system utilizing an analog signal amplitude to pulse width converter.

In process control, it is often necessary to sense a plurality of variables, such as temperature, static pressure, and differential pressure. The multiplexing of such signals onto a single analog-to-digital conversion device is known; "Electronic Design", Vol. 30, No. 19, Sep. 1982, pages 1215—129 shows such a system designed specifically to monitor a variety of thermocouples. The conversion of the analog signal from the multiplexer to digital form can be performed in conventional manner by a comparator fed with a triangular waveform, to convert the signal to a pulse width modulated (duty cycle) form, followed by counter means to measure the pulse width. To accommodate different ranges for different sensors, there may be a programmable variable gain amplifier provided between the multiplexer and the comparator.

Accordingly the present invention provides an analog signal communication system comprising:

an input multiplexer for selecting one of a plurality of analog input signals;

a variable gain amplifier for amplifying the output of the input multiplexer;

a free running triangle wave generator;

a comparator comparing the output of the variable gain amplifier and the triangle wave to produce a variable duty cycle signal; means for converting the variable duty cycle output signal to a digital word; and

digital signal handling means which modifies the digital word in accordance with a fixed procedure and controls the input multiplexer and the variable gain amplifier,

characterized in that one of the analog input signals is a compensation signal obtained from a temperature and time drift responsive circuit and the input selector is controlled by the digital signal handling means to select the compensation signal for each gain level selected.

An embodiment of the present invention will now be described, by way of example, with reference to the drawings, in which:—

Figure 1 is a block diagram of an analog signal conversion system, and

Figure 2 is a diagram of the sensor pulse modulator of the system.

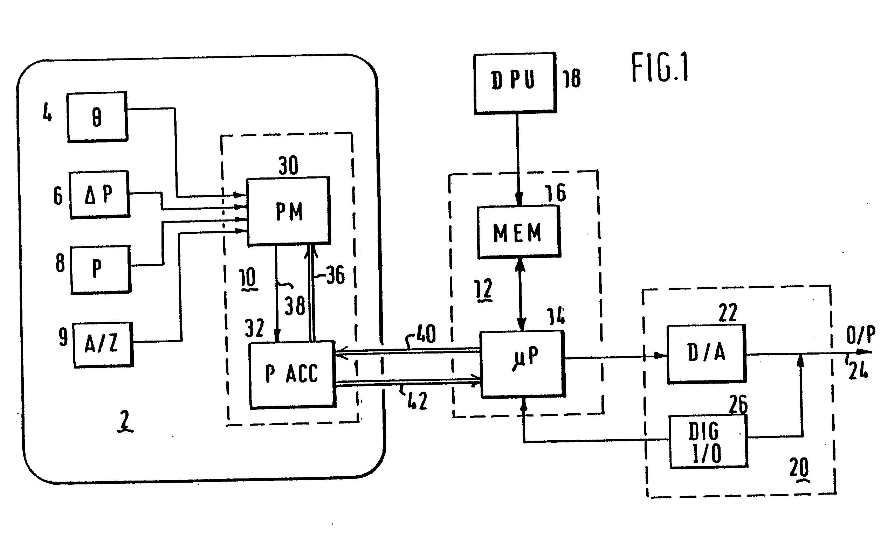

Figure 1 shows a process variable sensor system for modulating the output of process variable responsive sensors contained in a pressure housing 2. The sensors are a temperature sensor 4, a differential pressure sensor 6 and a static pressure sensor 8. These sensors and an auto-zero circuit 9 are connected through a shared sensor interface 10 to a signal conditioning and compensation system 12. The system 12 includes a microprocessor 14 having a memory 16 and may be physically attached to the pressure housing 2 so that it is a dedicated unit servicing the sensors 4, 6, 8 and sensor interface 10. A production computer 18 is used during the manufacture of the sensor system and supplies characterizing data to be stored in the memory 16 associated with the sensor interface 10, and the sensors in the pressure housing 2. A digital output from the microprocessor 14 is applied to a communication interface 20, which includes a digital-to-analog converter 22 to convert the digital output signals from the microprocessor 14 to 4—20 mA analog signals for application on analog signal output line 24 for subsequent control and communication with an industrial process (not shown). A digital input/output communication device 26 is also located in the interface 20 for providing digital communication between devices (not shown) connected to the output line 24.

The shared sensor interface 10 includes a sensor pulse modulator 30 which receives inputs from the temperature and pressure sensors 4, 6, 8 over an input line. The modulator 30 is connected to a pulse accumulator circuit 32 by a control line 36 and an output line 38. The pulse accumulator circuit 32, in turn, is connected to the microprocessor 14 by an input line 40 and an output line 42.

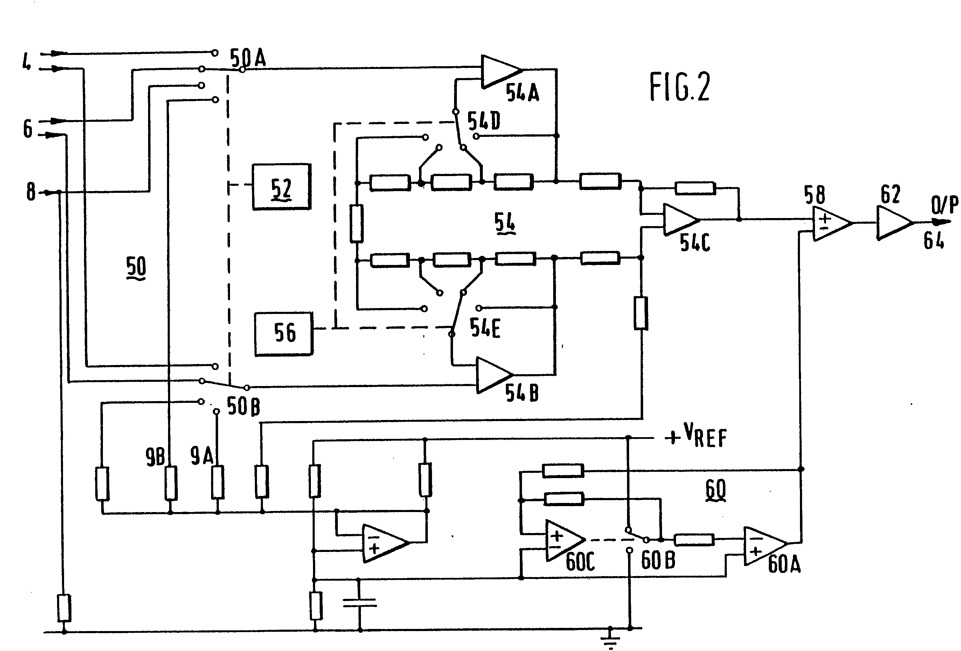

Figure 2 is a block diagram of the shared sensor pulse modulator 30 for producing a variable duty cycle output signal having a pulse width representation of a selected analog input signal. The sensor input lines from sensors 4, 6, and 8 and the auto-zero input 9 are connected to an input multiplexer 50 to be selected by control signals from an input selector 52 controlled, in turn, by an input select signal from the microprocessor 14. The auto-zero input is obtained from the auto-zero circuit 9 including a pair of resistors 9A, 9B energized by the $+V_{REF}$ source. Multiplexer 50 feeds a variable gain amplifier 54 having its gain controlled by control signals from a range selector 56 fed with a range select input signal from the microprocessor 14. The input select signal and the range select signal are applied to the modulator 30 over the modulator control line 36, Figure 1.

A comparator 58 is fed by the variable gain amplifier 54 and a free-running triangle wave generator 60. The comparator 58 feeds a buffer amplifier 62 providing a low impedance output and voltage level translation to an output 64 which feeds the pulse accumulator circuit 32, Figure 1.

In more detail, the multiplexer 50 is controlled by the input selector 52 which controls two multiplexer switches 50A, 50B for selecting the desired inputs. Although the switches 50A and 50B are shown as multi-pole switches, each is in fact a set of four electronic switches which are controlled by four respective outputs from the select circuit 52; each of the four outputs of the select circuit 52 is fed to two electronic switches, forming a quarter of each of the two switches 50A and 50B.

The two input signals so selected are fed to two dual amplifiers 54A and 54B, which have variable feedback resistor paths controlled by the select circuit 56 by means of two switches 54D and 54E, which are similar to the switches 50A and 50B. The dual amplifiers 54A, 54B feed a difference amplifier 54C which is used for amplification and level shifting of the input signals to produce an output on a single ended amplifier output for application to the comparator 58.

The second input to the comparator 58 is obtained from the free running triangular waveform generator 60. Briefly, the waveform generator 60 includes a voltage reference $+V_{REF}$, an integrator 60A, a switch 60B and a hysteresis comparator 60C. The operational integrator 60A provides an input to the comparator 60C and when the integrator outout reaches a so-called "trip point" of an input voltage hysteresis band, the output of the comparator changes state which, in turn, actuates the switch 60B between $+V_{REF}$ and earth to cause the output ramp signal to change direction to produce a triangular waveshape output signal from the generator 60.

The comparator 58 compares the voltage waveform output of the triangular waveform generator 60 with the selected sensor voltage applied through the multiplexer 50 and the variable gain amplifier 54. The output from the comparator 58 is low while the amplified and level shifted voltage is less than the output signal from the triangular waveform generator 60. Since this sensor or auto-zero voltage value changes with varying outputs from the sensors or auto-zero circuit, the duty cycle or pulse width of the output from the comparator 58 correspondingly changes.

The analog-to-digital conversion function is completed by the pulse accumulator circuit 32 (Figure 1) to convert the information contained in the duty cycle output of the sensor pulse modulator 30 into a digital word which is usable by the microprocessor 14. The pulse accumulator circuit 32 contains counters (not shown) for accumulating clock pulses during the "on" time of the duty cycle output signal from the sensor pulse modulator 30, and the count stored in the counter is subsequently read by the microprocessor 14 as a representation of the pulse width or duty cycle output of the sensor pulse modulator 30. For example, during the duty cycle output time of the output signal from the sensor pulse modulator 30, a first set of counters in the pulse accumulators circuit 32 accumulates clock pulses during the "on" time of the duty cycle waveform while a second set of counters counts clock pulses during the entire period of the output signal.

In summary, the pulse modulator 30 is the shared interface between the sensors 4, 6, 8 and the auto-zero circuit 9 and the digital electronics in the conditioning and compensation circuit 12. The pulse modulator 30 converts each of the sensor and auto-zero output voltages into a varying duty cycle output signal, and by proper selection of the selector 52 and the range selector 56, one of the available input signals and amplifier gains are selected. The output of the pulse modulator 30 is a free-running, pulse width modulated square wave with a frequency of operation determined by the frequency of the triangular wave generator 60. The analog signal output from the modulator 30 is converted into a digital representation, a stored count, by the pulse accumulator circuit 32 operating as an analog-to-digital converter. The counts from the accumulator 32 are transferred to the microprocessor 14 for use as digital representations of the duty cycle output from the sensor pulse modulator 30, i.e., sensor and auto-zero output signals. The microprocessor 14 stores the counts as digital words in the memory 16 and performs data handling operations thereon in accordance with a stored program.

An auto-zero measurement is made in all gain ranges selected by the range selector 56 on a successive or periodic basis by a selection of input 9 to the multiplexer 50. The value of the auto-zero signal obtained from the auto-zero resistors 9A, 9B is used, after an analog-to-digital conversion, by the microprocessor 14 to correct for zero error in the electronic circuitry caused by the temperature and/or time drift. Finally, the digital output from the microprocessor 14 is applied to a digital-to-analog converter 22 in the communication interface 20 to produce a corresponding analog current signal for application to a 4—20 mA communication line 24. This 4—20 mA signal can be utilized for process control in any conventional manner, such process control operations being well-known in the art.

## Claims

1. An analog signal communication system comprising:
an input multiplexer (50) for selecting one of a plurality of analog input signals;
a variable gain amplifier (54) for amplifying the output of the input multiplexer;
a free running triangle wave generator (60);
a comparator (58) comparing the output of the variable gain amplifier and the triangle wave to produce a variable duty cycle signal;
means (32) for converting the variable duty cycle output signal to a digital word; and
digital signal handling means (14, 16) which modifies the digital word in accordance with a fixed procedure and controls the input multiplexer and the variable gain amplifier,
characterized in that one of the analog input signals is a compensation signal obtained from a temperature and time drift responsive circuit (9) and the input selector is controlled by the digital signal handling means to select the compensation signal for each gain level selected.

2. A system according to claim 1, characterized by a housing means (2) including the sensor means (4, 6, 8) generating the analog input signals and the temperature and time drift responsive circuit (9), such that the components contained therein are subject to a common environment.

3. A system according to either previous claim, characterized in that the variable gain amplifier includes a pair of amplifiers each having a variable feedback impedance controlled by the digital signal handling means.

4. A system according to any previous claim, characterized in that the digital signal handling means includes a microprocessor and a digital memory for storing a fixed program for operating the microprocessor and characterized data corresponding to each analog input signal.

**Revendications**

1. Système de communication à signaux analogiques comprenant:

un multiplexeur d'entrée (50) pour sélectionner l'un d'une pluralité de signaux d'entrée analogiques;

un amplificateur à gain variable (54) pour amplifier la sortie du multiplexeur d'entrée;

un générateur d'onde triangulaire fonctionnant en continu (60);

un comparateur (58) comparant la sortie de l'amplificateur à gain variable et l'onde triangulaire pour produire un signal rapport cyclique variable;

un moyen (32) pour convertir le signal de sortie à rapport cyclique variable en un mot numérique; et

un moyen de traitement de signaux numériques (14, 16) qui modifie le mot numérique selon un processus fixé et commande le multiplexeur d'entrée et l'amplificateur à gain variable,

caractérisé en ce que l'un des signaux d'entrée analogiques est un signal de compensation obtenu à partir d'un circuit (9) agissant en réponse à la variation de température et au vieillissement et en ce que le sélecteur d'entrée est commandé par le moyen de traitement de signaux numériques pour choisir le signal de compensation pour chaque niveau de gain choisi.

2. Système selon la revendication 1, caractérisé par un moyen de boîtier (2) comprenant les moyens détecteurs (4, 6, 8) produisant les signaux d'entrée analogiques et le circuit (9) agissant en réponse à la variation de température et au vieillissement, de sorte que les composants qui y sont contenus sont soumis à un environnement commun.

3. Système selon l'une ou l'autre des revendications précédentes, caractérisé en ce que l'amplificateur à gain variable comprend une paire d'amplificateurs dont chacun comprend une impédance de réaction variable commandée par le moyen de traitement de signaux numériques.

4. Système selon l'une quelconque des revendications précédentes, caractérisé en ce que le moyen de traitement de signaux numériques comprend un microprocesseur et une mémoire numérique pour mémoriser un programme fixe pour faire fonctionner le microprocesseur et des données caractérisées correspondant à chaque signal d'entrée analogique.

**Patentansprüche**

1. Analoges Übertragungssystem, das aufweist:

einen Eingangsmultiplexer (50) zum Auswählen eines aus einer Vielzahl von analogen Eingangssignalen;

einen Verstärker (54) mit variablem Verstärkungsfaktor zum Verstärken des Ausgangs des Eingangsmultiplexers;

einen freilaufenden Dreieckswellengenerator (60);

einen Komparator (58), der den Ausgang des Verstärkers mit variablem Verstärkungsfaktor und die Dreieckswelle vergleicht, um ein variables Arbeitszyklussignal zu erzeugen;

Einrichtungen (32) zum Umwandeln des variablen Arbeitszyklusausgangssignals in ein digitales Wort; und eine Digitalsignalhandhabungseinrichtung (14, 16), die das digitale Wort in Übereinstimmung mit einer festgelegten Prozedur modifiziert und den Eingangsmultiplexer und den Verstärker mit variblem Verstärkungsfaktor steuert, dadurch gekennzeichnet, daß eines der analogen Eingangssignale ein Kompensationssignal ist, das von einem Temperatur- und Zeitdrifftantwortkreis (9) erhalten wird und der Eingangsauswähler gesteuert wird durch die Digitalsignalhandhabungseinrichtung, um das Kompensationssignal für jeden ausgewählten Verstärkungspegel auszuwählen.

2. System nach Anspruch 1, gekennzeichnet durch eine Gehäuseeinrichtung (2), die die Sensoreinrichtungen (4, 6, 8), die die analogen Eingangssignale erzeugen, und den Temperatur- und Zeitdriftantwortkreis (9) aufweist, so daß die Komponenten, die darin enthalten sind, einer gemeinsamen Umgebung ausgesetzt sind.

3. System nach einem der vorangehenden Ansprüche, dadurch gekennzeichnet, daß der Verstärker mit variablem Verstärkungsfaktor ein Paar von Verstärkern aufweist, die jeweils eine variable Rückführimpedanz haben, die durch die digitale Signalhandhabungseinrichtung gesteuert wird.

4. System nach irgendeinem der vorangehenden Ansprüche, dadurch gekennzeichnet, daß die digitale Signalhandhabungseinrichtung einen Mikroprozessor und einen digitalen Speicher zum Speichern eines festgelegten Programms zum Betreiben eines Mikroprozessors und gekennzeichneter Daten, die jedem analogen Eingangssignal entsprechen, aufweist.

FIG.1

FIG.2